**Europäisches Patentamt**

**European Patent Office**

**Office européen des brevets**

(19)

(11) Veröffentlichungsnummer: **0 007 625**
**B1**

(12) **EUROPÄISCHE PATENTSCHRIFT**

(45) Veröffentlichungstag der Patentschrift: **20.05.81**

(51) Int. Cl.³: **H 03 H 15/02, H 01 L 27/10**

(21) Anmeldenummer: **79102648.7**

(22) Anmeldetag: **25.07.79**

(54) **Elektrische Filterschaltung mit aus einzelnen CTD-Elementen bestehenden CTD-Leitungen.**

(30) Priorität: **26.07.78 DE 2832795**

(43) Veröffentlichungstag der Anmeldung:
**06.02.80 Patentblatt 80/3**

(45) Bekanntmachung des Hinweises auf die Patenterteilung:
**20.05.81 Patentblatt 81/20**

(84) Benannte Vertragsstaaten:
**AT BE CH DE FR IT NL SE**

(56) Entgegenhaltungen:
**DE - A - 2 534 319**
**DE - A - 2 608 582**

(73) Patentinhaber: **SIEMENS AKTIENGESELLSCHAFT**
**Berlin und München**
**Postfach 22 02 61**
**D-8000 München 22 (DE)**

(72) Erfinder: **Betzl, Hermann, Dipl.-Ing.**
**Albert-Rosshaupterstrasse 130**
**D-8000 München 70 (DE)**
Erfinder: **Hebenstreit, Ernst, Dipl.-Ing.**
**Gunzenlehstrasse 26**
**D-8000 München 21 (DE)**
Erfinder: **Schreiber, Roland, Dr.-Ing.**
**Hochenbrunnerstrasse 61**
**D-8012 Ottobrunn-Riemerling (DE)**

# Elektrische Filterschaltung mit aus einzelnen CTD-Elementen bestehenden CTD-Leitungen

Die Erfindung betrifft eine elektrische Filterschaltung mit aus einzelnen CTD-Elementen bestehenden CTD-Leitungen unter Verwendung von Vierpolresonatoren, die jeweils als in sich geschlossene Leitungsschleife ausgebildet sind und die das frequenzabhängige Übertragungsverhalten der Filterschaltung bestimmen, und bei der weiterhin aufeinanderfolgende Vierpolresonatoren über eine Koppelschaltung miteinander verbunden sind.

Filterschaltungen der vorgenannten Art sind beispielsweise dem Grundkonzept nach bereits aus der DE—PS 24 53 669 bekannt geworden. Spezielle Ausgestaltungen solcher Schaltungen sind ferner in der DE—AS 25 34 319 sowie auch in der DE—AS 26 08 582 beschrieben. In diesen Druckschriften ist u.a. auch darauf hingewiesen, daß unter CTD-Leitungen einerseits sogenannte BBD-Anordnungen (Bucked Brigade Devices), also sogenannte Eimerkettenschaltungen und andererseits auch sogenannte CCD-Anordnungen (Charged Coupled Devices) zu verstehen sind. CCD-Schaltungen sind solche Einrichtungen, die nach dem Prinzip der gekoppelten Ladungen arbeiten. Es hat sich für diese beiden Schaltungsarten in der Fachsprache auch die Bezeichnung "CTD-Einrichtung" (Charge Transfer Devices) eingebürgert, und es ist für diese Art von Übertragungseinrichtungen u.a. charakteristisch, daß sie unidirektionales Übertragungsverhalten haben. CTD-Einrichtungen bestehen aus einer größeren ganzzahligen Anzahl, also beispielsweise n einzelnen CTD-Elementen, die als vollintegrierbare Gesamtanordnungen realisiert werden können. Bekanntlich müssen solche CTD-Anordnungen über ein Taktsignal mit einer vorgebbaren Taktfrequenz $f_T$ betrieben werden, wobei das Taktsignal den einzelnen Umladekondensatoren der BBD-Anordnungen bzw. den Umladekapazitäten der CCD-Leitungen zugeführt wird. In der Praxis werden dabei sogenannte Mehrphasen-CTD-Anordnungen bevorzugt, deren Taktsignale zueinander phasenverschoben sind, und zwar derart, daß benachbarte Umladekapazitäten mit phasenverschobenen Takten betrieben werden. Wenn man demzufolge ein sogenanntes p-Phasentaktsystem ($p = 2, 3, 4 \ldots$) verwendet, dann besteht ein CTD-Element aus p benachbarten Umladekapazitäten. Weitere Einzelheiten hierüber finden sich z.B. in dem Buch "Charged Transfer Devices", Academic Press Inc., New York, San Francisco, London 1975.

Filterschaltungen nach der DE—PS 24 53 669 bzw. nach der DE—AS 25 34 319 bzw. auch nach der DE—AS 26 08 582 verwenden als resonanzfähige Strukturen in sich geschlossene Leitungsschleifen, die im folgenden als Vierpolresonatoren bezeichnet werden. In der DE—AS 25 34 319 sind noch Ein- und Auskoppelschaltungen gezeigt, die in der Topologie von Kreuzgliedschaltungen ausgebildet sind, wobei für den Schaltungsaufbau die Eigenschaften der CTD-Anordnungen berücksichtigt werden muß. Bei den in der DE—AS 26 08 582 gezeigten Ein- und Auskoppelschaltungen wird hinsichtlich der Schaltungsstruktur die Topologie von $\pi$-Gliedern verwendet. Für die Filtercharakteristik ist dabei mitbestimmend das Verhältnis der Umladekapazitäten der in den Zuführungsleitungen verwendeten CTD-Anordnungen zu der Umladekapazität der in der geschlossenen Leiterschleife, d.h. also zu der im Vierpolresonator verwendeten CTD-Anordnung.

Obzwar die bekannten Filterschaltungen nur einen verhältnismäßig geringen Raumverbrauch auf Grund ihrer integrierten Aufbauweise in Anspruch nehmen, wird man bestrebt sein, solche Schaltungen mit einer möglichst geringen Anzahl von CTD-Elementen zu realisieren.

Der Erfindung liegt die Aufgabe zugrunde, Filterschaltungen in CTD-Technik anzugeben, bei denen die volle Integrierbarkeit bei einer möglichst geringen Zahl von CTD-Elementen erhalten bleibt.

Ausgehend von den einleitend genannten Filterschaltungen, wird diese Aufgabe erfindungsgemäß dadurch gelöst, daß die Endresonatoren ebenfalls als in sich geschlossene Leitungsschleife ausgebildet sind.

Vorteilhafte Ausgestaltungen sind noch in den Unteransprüchen angegeben.

Anhand eines Ausführungsbeispieles wird nachstehend die Erfindung noch näher erläutert.

Bei der Erfindung wird von der Überlegung ausgegangen, daß die in der DE—PS 24 53 669 und den deutschen Auslegeschriften 25 34 319 und 26 08 582 gezeigten Filterschaltungen an sich den Charakter von Weichenschaltungen haben.

Mit anderen Worten heißt dies, daß bei diesen bekannten Schaltungen zwei Eingänge und auch zwei Ausgänge zur Verfügung stehen. Wenn dabei die Signalfrequenz $f_s$ mit der Resonanzfrequenz $f_R$ der in sich geschlossenen Leiterschleifen, d.h. also, mit der Resonanzfrequenz der Vierpolresonatoren, übereinstimmt, dann wird die am ersten Eingang eingespeiste Signalenergie auch am ersten Ausgang abgegeben. Es wird aber ein umso größerer Anteil der am ersten Eingang eingespeisten elektrischen Energie dem zweiten Ausgang zugeführt, je weiter die Signalfrequenz $f_s$ in ihrer Frequenzlage von der Resonanzfrequenz $f_R$ der Vierpolresonatoren entfernt ist. Umgekehrt wird auch am zweiten Eingang eingespeiste Signalenergie nahezu dann vollständig am zweiten Ausgang abgegeben, wenn die Signalenergie $f_s$ und die Reso-

nanzfrequenz $f_R$ der Vierpolresonatoren möglichst übereinstimmen. Mit zunehmender Abweichung von dieser Bedingung wird in analoger Weise ein zunehmend größerer Anteil der Signalenergie am ersten Ausgang abgegeben.

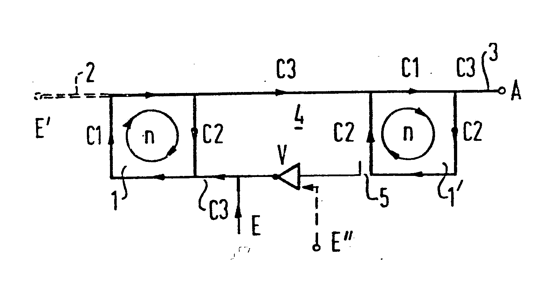

In der beigefügten Zeichnung ist ein Ausführungsbeispiel gezeigt, bei dem nun davon ausgegangen ist, daß der Weichencharakter der bekannten Schaltungen in vielen Anwendungsfällen an sich nicht erforderlich ist, so daß also nur mehr ein Filtereingang und ein Filterausgang zur Verfügung stehen. In seiner Eigenschaft als Filterschaltung ist jedoch auch die gezeigte Schaltung voll funktionstüchtig und sie kann dabei gleichzeitig mit einer möglichst geringen Anzahl von CTD-Elementen aufgebaut werden. Auch können innerhalb der Schaltung Verstärker am Eingangs- bzw. Ausgangskreis eingespart werden, weil die an sich nicht benötigten Anschlußarme fortfallen.

In der gezeichneten Schaltungsstruktur stellen die breit ausgezogenen Linien CTD-Leitungen dar, deren unidirektionales Übertragungsverhalten durch die in die einzelnen Leitungsabschnitte miteingetragenen Pfeile kenntlich gemacht ist. Die in der Figur dünn gezeichneten Linien sind galvanische Leitungsverbindungen, deren unidirektionales Übertragungsverhalten durch die Signalflußrichtungen der in diese Leitungen eingeschalteten Verstärker bestimmt wird. Wie bereits erwähnt, ist in der Zeichnung als Beispiel ein zweikreisiges Filter gezeichnet, so daß also die beiden Endresonatoren 1 und 1' zugleich die einzigen Filterresonatoren sind. Diese beiden Resonatoren sind über eine Koppelschaltung 4 miteinander verbunden. Die beiden vereinfachten Vierpolresonatoren 1 und 1' bestehen aus CTD-Leitungen, von denen drei Leitungsabschnitte der in sich geschlossenen Leitungsschleife die Umladekapazität C1 bzw. C2 haben. Die der Koppelschaltung 4 zugewandten Leitungsabschnitte haben die Umladekapazität C2. Durch die in die Zeichnung eingetragenen, in sich geschlossenen Pfeile, soll kenntlich gemacht werden, daß die Resonatoren 1 und 1' n CTD-Elemente haben, so daß also für ihre Resonanzfrequenz $f_R$ folgende Beziehung gilt $f_R = k \cdot f_T/n$ (k = 1, 2 . . . . . . n)

Die Koppelschaltung besteht aus einem CTD-Leitungsabschnitt mit der Umladekapazitä C3, der die oberen Längsleitungen der Vierpolresonatoren 1 und 1' verbindet. Wie der gezeichneten Schaltung unmittelbar zu entnehmen ist, sind nun die Endresonatoren 1 und 1' vollständig als in sich geschlossene CTD-Leitungsschleifen ausgebildet. Dabei schließt sich dem Ausgangsresonator 1' ein CTD-Leitungsstück 3 an, an dem auch der Ausgang A der Filterschaltung liegt.

Zur Realisierung der Eingangsschaltungen bestehen nun mehrere Möglichkeiten, die im Ausführungsbeispiel mit E bzw. E' bzw. E'' bezeichnet sind.

Es kann nämlich die die unteren Leitungsabschnitte der Vierpolresonatoren 1 und 1' verbindende Leitung der Koppelschaltung 4 einen Leitungsabschnitt mit der Umladekapazität C3 enthalten, dessen Übertragungsrichtung vom Resonator 1' zum Resonator 1 zeigt. In diesem Fall besteht die Möglichkeit diesen Leitungsabschnitt an seinem Eingang aufzuspalten, und das Eingangssignal am Eingang E einer der abgespalteten Teilleitungen zuzuführen.

Eine weitere Möglichkeit besteht darin, das Eingangssignal am Eingang E' einzuspeisen. Im Ausführungsbeispiel wird hierzu der Eingang E' über eine CTD-Leitung 2 mit der oberen Längsleitung des Resonators 1 verbunden. In den beiden vorgenannten Fällen ist der Verstärker ein einfacher Verstärker mit nur einem Eingang.

Auch kann zur Zuführung des Eingangssignals, wie im Ausführungsbeispiel ebenfalls gestrichelt für den Eingang E'' dargestellt ist, das Signal einem Summierverstärker V mit zwei Eingängen und einem Ausgang zugeführt werden. Mit Rücksicht auf die verwendete Koppelschaltung ist im Ausführungsbeispiel der Summierverstärker V ein invertierender Verstärker, d.h. sein Verstärkungsfaktor ist mit negativem Vorzeichen behaftet, so daß also stets die Ausgangssignale in Gegenphase zu den Eingangssignalen sind. Der Verstärker V liegt im rückführenden Zweig der Koppelschaltung 4, so daß seine Signalflußrichtung also vom Resonator 1' zum Resonator 1 zeigt. CTD-Elemente lassen sich vor allem noch dadurch einsparen und fertigungstechnisch günstige Kapazitätswerte für die Umladekapazitäten des Ausgangsresonators erreichen, daß die gesamte rückführende Leitung der Koppelschaltung 4 als galvanische Leitung ausgebildet ist, und zugleich der rückzuleitende Signalanteil über eine leistungslose Auskopplung aus dem Resonator 1' ausgekoppelt wird. Diese leistungslose Auskopplung ist als eigenes Schaltsymbol in der Figur dargestellt und mit der Bezugsziffer 5 bezeichnet. Solche leistungslose Auskopplungen sind für sich bekannt, so daß hier nicht im einzelnen darauf eingegangen werden muß. Insbesondere sei verwiesen auf das Buch "Charged Transfer Devices" Academic Press Inc. New York, San Francisco, London 1975 und dort insbesondere auf die Seiten 53 bis 57, wo solche Auskopplungen für CTD-Schaltungen beschrieben sind. In analoger Weise lassen sich für BBD-Schaltungen die Umladekondensatoren abtasten, wenn der darauffolgende Verstärker in seinem Eingangswiderstand möglichst dem Wert Unendlich zustrebt. Im vorgenannten Buch sind insbesondere auf den Seiten 47 bis 61 auch Schaltungen beschrieben, die geeignet sind, Analogsignale in Signale umzuformen, die für die Weiterverarbeitung in CTD-Technik geeignet sind, bzw. auch umgekehrt in CTD-Technik verarbeitete Signale in Analogsignale rückzuverwandeln.

## Patentansprüche

1. Elektrische Filterschaltung mit aus einzelnen CTD-Elementen bestehenden CTD-Leitungen (C1—C3) unter Verwendung von Vierpolresonatoren (1, 1'), die jeweils als in sich geschlossene Leitungsschleife ausgebildet sind und die das frequenzabhängige Übertragungsverhalten der Filterschaltung bestimmen, und bei der weiterhin aufeinanderfolgende Vierpolresonatoren (1, 1') über eine Koppelschaltung (4) miteinander verbunden sind, dadurch gekennzeichnet, daß die Endresonatoren (1, 1') ebenfalls als in sich geschlossene Leitungsschleife ausgebildet sind.

2. Elektrische Filterschaltung nach Anspruch 1, dadurch gekennzeichnet, daß das Signal unmittelbar über eine CTD-Leitung (2, 3) dem Eingangsresonator (1) zugeführt (E') bzw. dem Endresonator (1') entnommen (A) wird.

3. Elektrische Filterschaltung nach Anspruch 1, dadurch gekennzeichnet, daß das Eingangssignal einem Summier-Verstärker (V) zugeführt (E'') wird, der im Zuge einer Koppelschaltung (4) angeordnet ist, die zwischen dem Eingangsresonator (1) und dem darauffolgenden Vierpolresonator (1') liegt.

4. Elektrische Filterschaltung nach einem der vorhergehenden Ansprüche, dadurch gekennzeichnet, daß in der dem Ausgangsresonator (1') vorgeschalteten Koppelschaltung (4) anstelle einer rückführenden CTD-Leitung das Signal unmittelbar leistungslos (5) aus dem Endresonator (1') ausgekoppelt wird.

## Claims

1. Electrical filter circuit which comprises CTD-lines (C1—C3) composed of individual CTD-elements, employing four-pole resonators (1, 1') each of which is constructed as a loop closed on itself and which determine the frequency-dependent transmission behaviour of the filter circuit, and wherein furthermore successive four-pole resonators (1, 1') are connected to one another via a coupling circuit (4), characterised in that the end resonators (1, 1') are likewise designed as loops which are closed on themselves.

2. Electrical filter circuit as claimed in claim 1, characterised in that the signal is fed (E') to the input resonator (1) and/or taken from the end resonator (1'), directly via a CTD-line (2, 3).

3. Electrical filter circuit as claimed in claim 1, characterised in that the input signal is fed (E'') to a summing amplifier (V) which is arranged in a coupling circuit (4) positioned between the input resonator (1) and the following four-pole resonator (1').

4. Electrical filter circuit as claimed in one of the preceding claims, characterised in that, in the coupling circuit (4) which precedes the output resonator (1'), in place of a return CTD-line the signal is directly output coupled from the end resonator (1') in a wattless fashion.

## Revendications

1. Montage de filtre électrique à conducteurs -CTD (C1—C3) constitués par des éléments CTD individuels, du type mettant en oeuvre des résonateurs quadripôles (1, 1') dont chacun est réalisé sous la forme d'une boucle de ligne fermée sur elle-même et déterminent le comportement du transfert du montage en fonction de la fréquence, et dans lequel les résonateurs quadripôles successifs (1, 1') sont reliés entre eux par un circuit de couplage (4), caractérisé par le fait que les résonateurs d'extrémité (1, 1') sont également réalisés sous la forme de boucles de lignes fermées sur elles-mêmes.

2. Montage de filtre électrique selon la revendication 1, caractérisé par le fait que le signal (E') est transmis directement, par l'intermédiaire d'un conducteur CTD (2, 3), au résonateur d'entrée (1) ou est prélevé (A) du résonateur terminal (1').

3. Montage de filtre électrique selon la revendication 1, caractérisé par le fait que le signal d'entrée (E'') est appliqué à un amplificateur de sommation (V) monté dans un circuit de couplage (4) situé entre le résonateur d'entrée (1) et le résonateur quadripôle (1') qui le suit.

4. Montage de filtre électrique selon l'une des revendications antérieures, caractérisé par le fait que dans le circuit de couplage (4) situé en amont du résonateur de sortie (1'), le signal est, à la place d'un conducteur -CTD de renvoi, découplé directement (5), et sans puissance, de résonateur terminal (1').